Europäisches Patentamt

European Patent Office

Office européen des brevets

(19)

(11) EP 0 800 206 A2

(12) EUROPEAN PATENT APPLICATION

(43) Date of publication:
08.10.1997 Bulletin 1997/41

(51) Int Cl.6: **H01L 21/768**, H01L 21/285, H01L 21/3205

(21) Application number: 97302303.9

(22) Date of filing: 03.04.1997

(84) Designated Contracting States:
DE FR GB IT NL

(30) Priority: 04.04.1996 US 14665 P

(71) Applicant: TEXAS INSTRUMENTS INCORPORATED
Dallas Texas 75265 (US)

(72) Inventor: Paranjpe, Ajit P.
Sunnyvale, California 94086 (US)

(74) Representative: Darby, David Thomas et al
Abel & Imray
Northumberland House
303-306 High Holborn
London WC1V 7LH (GB)

(54) **Method of simultaneously forming a contact/via plug and an interconnect**

(57)    An embodiment of the instant invention is a method of simultaneously forming a contact/via plug and interconnect over a semiconductor substrate for an electronic device, the method comprising: passing a gas through a precursor at a process pressure between 5 torr and 30 - torr, the passed gas having a flow rate through the precursor between 200 and 400 standard cubic centimetres per minute. Preferably, the gas is comprised of a gas selected from the group consisting of: inert gases, and hydrogen. More preferably, the gas is selected from the group consisting of: $H_2$, He, and Ar.

Preferably, the precursor is selected from the group consisting of: DMAH, TIBA, TMAA, TEAA, TMA, and DEAC1. Preferably, the process pressure is approximately 25 torr. Preferably, the contact/via plug and interconnect are comprised of a material selected from the group consisting of. aluminium, copper, and combination thereof. In another embodiment, a glue/liner/barrier layer is formed between the substrate and the contact/via plug and the interconnect. Preferably, the glue/liner/barrier layer is comprised a material selected from the group consisting of: TiN, Ti, and any combination thereof.

FIG. 1

## Description

FIELD OF THE INVENTION

The instant invention pertains to semiconductor device fabrication and processing and more specifically to deposition of aluminum films.

BACKGROUND OF THE INVENTION

Advanced VLSI devices utilize elaborate multi-level metallization schemes to enhance performance and achieve high functional integration. Metal deposition processes for barrier, contact/via plug, and interconnect formation are key enablers for multi-level metallization. The use of conventional sputtered aluminum for contact/via filling has been limited because of poor step coverage and poor planarization. However, sputtered aluminum is commonly used to form the interconnect.

Chemical Vapor Deposition (CVD) of tungsten is typically used as the contact/via plug, because of its high conformality and refractory nature, while sputtered aluminum is used for the formation of the interconnect. The process complexity of blanket etch-back (or chem-mechanical planarization) to form the tungsten plug followed by aluminum sputter deposition (physical vapor deposition -PVD) for interconnect formation in addition to the higher resistivity of tungsten (in comparison to aluminum) make it desirable to have a process which does not require the formation of a tungsten plug and an aluminum interconnect.

An acceptable process for the formation of the interconnect must provide smooth, low resistivity films that are not susceptible to hillock formation and stressvoiding and exhibit good electromigration resistance. In addition, a plug fill process must be void-free and must not increase junction leakage. CVD aluminum may be utilized in the formation of the plug and the interconnect; however traditional processing techniques cannot be utilized because they can not accomplish all of the above-stated criteria for the acceptable formation of the contact/via plug and interconnect. For example, aluminum films which are formed using traditional CVD techniques have a lot of carbon inclusions (which increases the resistivity of the aluminum film). In addition, aluminum films formed using traditional CVD techniques do not adequately fill fine features because the step coverage of these films is very poor. Also these films tend to be very rough, which results in a partial plug fill with voids between grains. In addition, when a thick film is required and the films are too rough, the films are difficult to pattern. Another problem with traditional CVD aluminum techniques are that they have low deposition rates.

It is, therefore, an object of the instant invention to provide a process for the formation of a contact/via plug along with an interconnect with acceptable deposition rates while providing a smooth film which properly fills the contact/via. In addition, it is an object of the instant invention to provide a plug and interconnect which has an acceptable resistivity and which have acceptable resistance to electromigration.

SUMMARY OF THE INVENTION

Advanced high-performance sub-half micron interconnects with polymeric dielectrics have made the development and implementation of sub-400°C plug fill and interconnect processing essential. Traditional problems with CVD aluminum include low deposition rates, poor surface morphology for thick films, inadequate electromigration resistance, and reactions between the aluminum precursors and residual gases in the process chamber. The method of the instant invention is one which overcomes these problems while facilitating the formation of both a contact/via plug and an interconnect. In addition., CVD of aluminum for simultaneous plug and interconnect formation can be effectively achieved using a low thermal budget with the method of the instant invention.

An embodiment of the instant invention is a method of simultaneously forming a contact/via plug and interconnect over a semiconductor substrate for an electronic device, the method comprising: passing a gas through a precursor at a process pressure between 5 torr and 30 torr, the passed gas having a flow rate through the precursor between 200 and 400 standard cubic centimeters per minute. Preferably, the gas is comprised of a gas selected from the group consisting of inert gases, and hydrogen. More preferably, the gas is selected from the group consisting of: $H_2$, He, and Ar. Preferably, the precursor is selected from the group consisting of DMAH, TIBA, TMAA, TEAA, TMA, and DEAC1. Preferably, the process pressure is approximately 25 torr. Preferably, the contact/via plug and interconnect are comprised of a material selected from the group consisting of aluminum, copper, and combination thereof.

In another embodiment, a glue/liner/barrier layer is formed between the substrate and the contact/via plug and the interconnect. Preferably, the glue/liner/barrier layer is comprised of a material selected from the group consisting of TiN, Ti, and any combination thereof.

Another embodiment of the instant invention is a method of forming a contact/via and interconnect on a semiconductor wafer and over a semiconductor substrate for an electronic device in a single process step, the method comprising the steps of: forming a glue/liner/barrier layer over the substrate by subjecting the substrate to a metal-organic precursor; inserting the semiconductor wafer into a process chamber, the process chamber having a process pressure; and forming the contact/via and interconnect by means of chemical vapor deposition of Al, the chemical vapor deposition of aluminum accomplished by bubbling a carrier case with a flow rate of between 200 and 400 sccm through a second precursor at the process pressure of between 10 and 40 torr. Preferably, the carrier gas is comprised of a gas selected from the group consisting of: inert gases, and hydrogen. More preferably, the carrier gas is selected from the group consisting of: $H_2$, He, and Ar. Preferably, the second precursor is selected from the group consisting of DMAH, TIBA, TMAA, TEAA, TMA, and DEAC1. Preferably, the process pressure is approximately 25 torr. Preferably, the glue/liner/barrier layer is comprised of a material selected from the group consisting of: TiN, Ti, and any combination thereof.

BRIEF DESCRIPTION OF THE DRAWINGS

The present invention will now be described, by way of example, with reference to the accompanying drawings in which:

FIGURE 1 is a cross-sectional view of a structure formed using an embodiment of the instant invention;
FIGURE 2 is a schematic of a single-wafer process chamber for the deposition of a metal layer which can be utilized to form the metal layer of the instant invention; and
FIGUREs 3a-3e are contour graphs of characteristics of the metal layer formed using an embodiment of the instant invention;

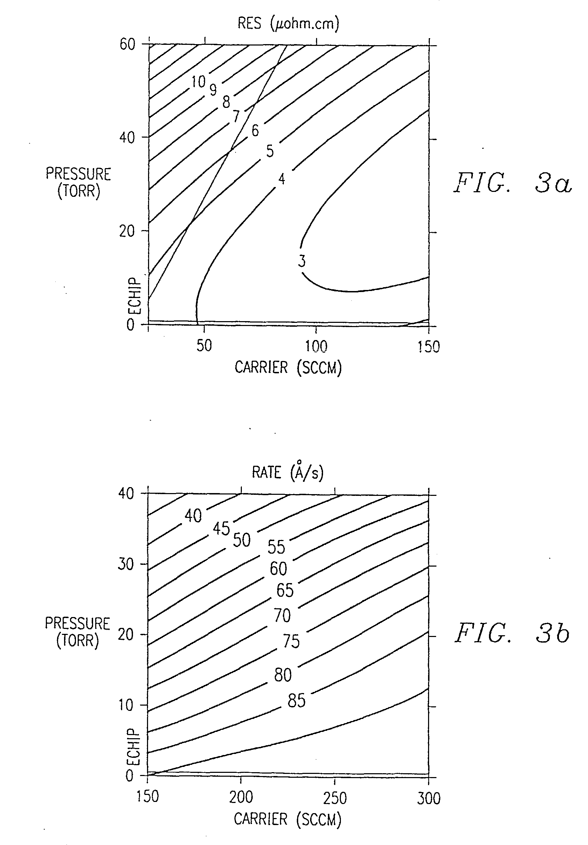

FIGURE 3a illustrates the resistivity, in $\mu\Omega cm$, as a function of carrier gas flow rate and pressure;
FIGURE 3b illustrates the deposition rate, in Å/s, as a function of carrier gas flow rate and pressure;
FIGURE 3c illustrates the deposition non-uniformity, in %, as a function of carrier gas flow rate and pressure;

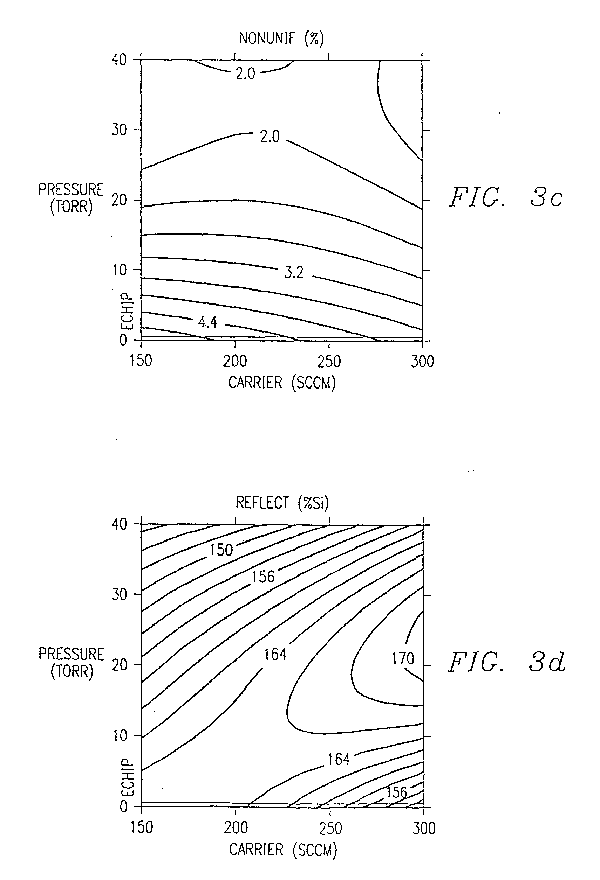

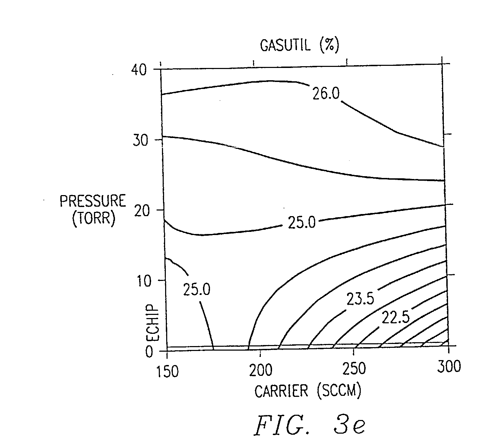

FIGURE 3d illustrates the reflectance, in % Si at 480nm., as a function of carrier gas flow rate and pressure; and
FIGURE 3e illustrates the gas utilization, in %, as a function of carrier gas flow rate and pressure.

DETAILED DESCRIPTION OF THE DRAWINGS

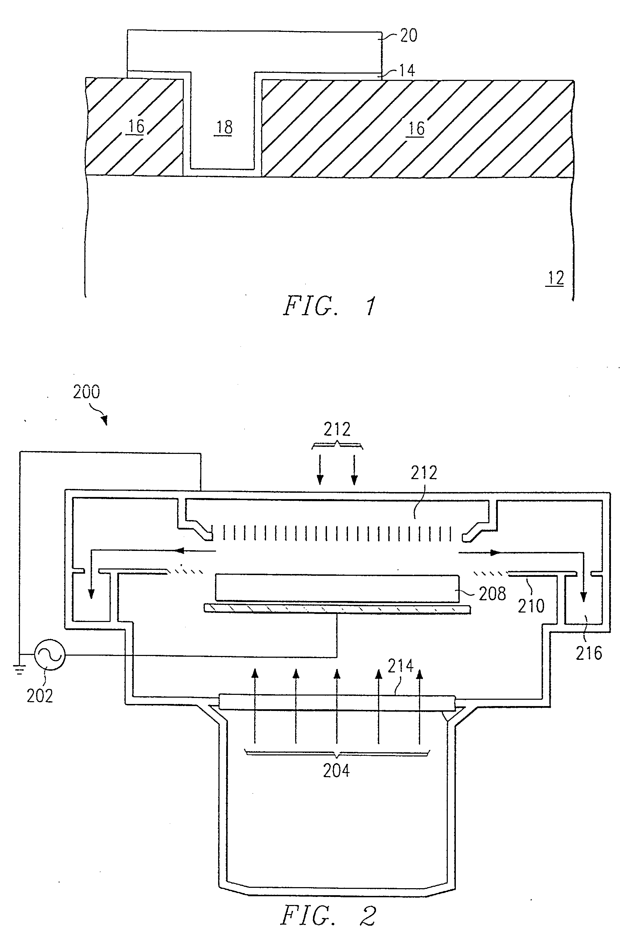

FIGURE 1 illustrates the type of contact/via plug and interconnect which can be formed using an embodiment of the instant invention. While FIGURE 1 illustrates a contact plug, it should be apparent, in reference to this specification, to one of ordinary skill that this type of process can be utilized to form via plugs. In view of this, the following discussion will revolve around FIGURE 1 and the formation of a contact. Preferably, some form of interlevel dielectric 16 (preferably an oxide layer, glass, BPSC, PSG or any other interlevel dielectric) is formed and patterned on substrate 12. After the formation and patterning of interlevel dielectric 16, glue/liner/barrier layer 14 may optionally be formed. The glue/liner/barrier layer can be a multi-layer film such as TiN/Ti. Using an embodiment of the instant invention., the topmost layer of glue/liner/barrier layer 14 is preferably formed (preferably in situ) by exposing the wafer to a metal-organic precursor. Preferably, the top most layer of glue/liner/barrier layer 14 is comprised of TiN, and is preferably of the order of 30 to 100Å thick. In such a case, this is formed, using an embodiment of the instant invention, by subjecting the wafer (preferably by bubbling a nitrogen gas through the metal-organic precursor) to any of the following metal-organic prescursors: TDMAT (tetrakis dimethyl amino titanium), TDEAT, $TiCl_4$, or $TiI_4$. In fact, this may be accomplished in the same chamber or in second chamber which is mounted on the same cluster tool. If the top most layer of glue layer 14 is formed from CVD TiN, it provides a very reactive surface with many dangling bonds, and thereby acts as a nucleation layer for a subsequent aluminum deposition. As a consequence there will be many places (nucleation sites) on glue layer 14 for the CVD Al grains to nucleate. As each grain of Al starts to grow from these nucleation sites, it will abut another grain thereby stopping its growth in that direction. The size of the Al grains decreases with increasing density of nucleation cites. Smaller grains result in smoother films and films less apt to have voids.

However, if the grains are too small, the electromigration resistance of the films degrades. Hence, the number of nucleation cites is optimized using an embodiment of the instant invention so as to achieve optimal electromigration properties while achieving optimal smoothness and reducing voids.

After glue layer 14 is formed, if it is to be formed, contact/via plug 18 and interconnect 20 are formed. If glue layer 14 is not formed, than contact/via plug 18 and interconnect 20 are formed abutting interlevel dielectric layer 16. In one embodiment of the instant invention, contact/via plug 18 and interconnect 20 are formed by CVD Al. In this embodiment, the CVD of Al is accomplished by bubbling a carrier gas (preferably any inert gas other than nitrogen -- preferably $H_2$, He, or Ar) through a precursor (preferably dimethyl aluminum hydride -- DMAH; or any of the following precursors can be used: TIBA, TMAA, TEAA, TMA, or DEACl). Preferably this is accomplished at a pressure between 10 and 40 torr (preferably approximately 25 torr) with a flow rate of carrier gas (preferably $H_2$ gas) through precursor (preferably DMAH) of approximately 200 to 400 sccm for a 150 mm wafer. Proportionately higher flow rates may be necessary for larger substrate and chamber sizes.

Referring to FIGURE 2, process chamber 200 may be utilized to form the metal layer of the instant invention. CVD process chamber 200 includes temperature controlled showerhead 212, temperature controlled susceptor 208, and temperature controlled walls (preferably controlled to be cold), RF source 202, pumping plates 210, quartz window 214 which allows light 204 to reach susceptor 208 so as to heat susceptor 208, and vacuum channel 216. The showerhead 212 is RF powered (not shown) so that a plasma can be generated to clean the inner surfaces of the chamber between depositions if necessary. In addition, plasma surface cleaning and non-selective plasma assisted aluminium deposition may be performed prior to the thermal CVD process so as to improve film morphology.

Preferably, the wafer is not clamped to the lamp heated susceptor, which allows full coverage deposition with zero edge exclusion. However, since the wafer is not clamped to susceptor 208, there is a temperature differential between the wafer and susceptor 208. This temperature differential is a function of the chamber pressure and is approximately 20°C at a pressure of approximately 25 torr.

Preferably, the wafer is situated on the chuck. Next, process gas is passed through showerhead 212 and the pressure in process chamber 200 is stabilized to a setpoint pressure (preferably at a process temperature of between 220 and 280°C) . AS is described above, the result of passing the process gas into the chamber is the formation of desired film of the wafer. After the film is formed to the desired thickness, the flow of the process gas through showerhead 212 and into the chamber is discontinued and the pressure in the chamber is stepped down. After the pressure is stepped down to approximately equivalent to the ambient pressure, the wafer is removed from process chamber 200.

The actual flow rate of the precursor (preferably DMAH) may not be controlled, but the flow rate of the carrier gas (preferably $H_2$) through the bubbler should be controlled. The flow rate of the precursor is estimated from the total pressure in the bubbler, and the carrier gas flow rate and the partial pressure of the precursor can be determined by:

$$Q_{precursor} = \frac{P_{precursor}}{P_{AMP} - P_{precursor}} \times Q_{CARRIER}$$

where $Q_{precursor}$ is the flow rate of precursor, $P_{precursor}$ is the vapor pressure of the precursor at the temperature of the bubbler, $P_{AMP}$ is the total bubbler pressure and $Q_{CARRIER}$ is the flow rate of the carrier gas through the bubbler. This assumes that the partial pressure of the precursor is equivalent to its vapor pressure which is generally true for a well designed bubbler. The vapor pressure of the precursor in the bubbler (in Torr) can be determined by:

$$\log P_{precursor} = -2575/(T + 8.92)$$

where T is the absolute temperature.

The deposition rate of the CVD Al increases with increasing carrier gas flow rate. The dependence of the deposition rate on the diluent H2 flow rate suggests that the deposition rate has a zero order dependence on the $H_2$ concentration. In addition, the decrease in deposition rate with increasing pressure suggests a multi-step surface reaction. The deposition non-uniformity decreases with increasing carrier gas flow rate and it is minimized for processing pressures between 10 and 30 torr.

Film reflectance (which is an indictor of grain size, surface roughness, and nucleation density) improves with increasing carrier gas flow rate and decreasing diluent $H_2$ flow rates. It is maximized for processing pressures of around 10 to 30 torr.

The process of forming a contact/via plug and interconnect of the instant invention yields a 99% purity smooth aluminium film with a bulk resistivity below $3\mu\Omega$cm at a deposition rate exceeding 4500 Å/min with void-free filling of a 0.3µm 4:1 aspect ratio contact/via.

Referring to FIGUREs 3a-3e, resistivity decreases with increasing carrier flow, and is minimized for a process pressure of approximately 10 to 30 torr. However, the diluent flow rate has little impact on the resistivity of the film. In addition, deposition rate increases with increasing carrier flow and decreasing pressure. Non-uniformity and reflectance are at preferred levels at process pressure of approximately 20 to 30 torr.

Although specific embodiments of the present invention are herein described, they are not to be construed as limiting the scope of the invention. Many embodiments of the present invention will become apparent to those skilled in the art in light of methodology of the specification.

## Claims

1. A method of simultaneously forming a contact/via plug and interconnect over a semiconductor substrate said method comprising:

    passing a gas through a precursor at a process pressure between 5 torr and 30 torr, said passed gas having a flow rate through said precursor between 200 and 400 standard cubic centimetres per minute.

2. The method of Claim 1, wherein said step of passing a gas comprises passing a gas selected from the group consisting of inert gases, and hydrogen.

3. The method of Claim 1 or Claim 2, wherein said step of passing a gas comprises passing a gas selected from the group consisting of: $H_2$, He, and Ar.

4. The method of any preceding claim, wherein said step of passing a gas through a precursor comprises passing the gas through a precursor selected from the group consisting of. DMAH, TIBA, TMAA, TEAA, TMA, and DEAC1.

5. The method of any preceding claim, further comprising passing the gas through said precursor at a process pressure of approximately 25 torr.

6. The method of any preceding claim, further comprising forming a glue/liner/barrier layer between said substrate and said contact/via plug and said interconnect.

7. The method of Claim 6, wherein said step of forming said glue/liner/barrier layer comprises forming said glue/liner/barrier layer from a material selected from the group consisting of: TiN, TI, or any combination thereof.

8. The method of any preceding claim, wherein said step of forming said contact/via plug and interconnect comprises forming said contact/via plug and interconnect from a material selected from the group consisting of: aluminium, copper, or any combination thereof.

9. A method of forming a contact/via and interconnect on a semiconductor wafer and over a semiconductor substrate in a single process step, said method comprising the steps of:

    forming a glue/liner/barrier layer over said substrate by subjecting said substrate to a metal-organic precursor;
    inserting said semiconductor wafer into a process chamber, said process chamber at a predetermined process pressure; and
    forming said contact/via and interconnect by means of chemical vapor deposition of aluminium, said chemical vapor deposition of aluminium accomplished by bubbling a carrier gas with a flow rate of between 200 and 400 sccm through a second precursor at said process pressure of between 10 and 40 torr.

10. The method of Claim 9, wherein said step of bubbling said carrier gas comprised bubbling a carrier gas selected from the group consisting of; inert gases, and hydrogen.

11. The method of Claim 9 or Claim 10, wherein said step of bubbling said carrier gas comprises bubbling a carrier gas selected from the group consisting of $H_2$, He, and Ar.

12. The method of any of Claims 9 to 11, wherein said step of bubbling said carrier gas through said second precursor comprises bubbling said carrier gas through a second precursor selected from the group consisting of: DMAH, TIBA, TMAA, TEAA, TMA, and DEAC1.

13. The method of any of Claims 9 to 12, further comprising bubbling said carrier gas through said second precursor at a process pressure of approximately 25 torr.

14. The method of any of Claims 9 to 13, wherein said step of forming said glue/liner/barrier layer comprises forming a glue/liner/barrier layer from a material selected from the group consisting of: TiN, Ti, or any combination thereof.

FIG. 1

FIG. 2

RES (μohm.cm)

FIG. 3a

RATE (Å/s)

FIG. 3b

NONUNIF (%)

FIG. 3c

REFLECT (%Si)

FIG. 3d

GASUTIL (%)

FIG. 3e